(19)

Europäisches
Patentamt
European
Patent Office
Office européen
des brevets

(11) **EP 2 224 589 A1**

(12) **EUROPEAN PATENT APPLICATION**

(43) Date of publication:
**01.09.2010 Bulletin 2010/35**

(51) Int Cl.:
*H03B 5/32* (2006.01)     *H03H 9/24* (2006.01)

(21) Application number: **09153565.8**

(22) Date of filing: **25.02.2009**

| | |
|---|---|
| (84) Designated Contracting States:<br>**AT BE BG CH CY CZ DE DK EE ES FI FR GB GR HR HU IE IS IT LI LT LU LV MC MK MT NL NO PL PT RO SE SI SK TR**<br>Designated Extension States:<br>**AL BA RS**<br><br>(71) Applicant: **NXP B.V.**<br>**5656 AG Eindhoven (NL)** | (72) Inventors:<br>• **van Beek, Jozef Thomas Martinus**<br>  **5656 AG Eindhoven (NL)**<br>• **Vermeeren, Petrus Antonius Thomas Marinus**<br>  **5656 AG Eindhoven (NL)**<br><br>(74) Representative: **Krott, Michel et al**<br>**NXP B.V.**<br>**Intellectual Property & Licensing Department**<br>**High Tech Campus 32**<br>**5656 AE  Eindhoven (NL)** |

(54)    **Oscillator circuit comprising a resistor element buffering a resonator output from peripheral loads**

(57)    It is described an electronic oscillator circuit (390). The electronic oscillator circuit (390) comprises a MEMS resonator (300c), a first resistor element (312a), which is coupled to the resonator (300c) in such a manner, that the resistance of the first resistor element (312a) changes when the resonator (300c) resonates, and a second resistor element (312b), which is connected downstream with respect to the resonator (300c) in such a manner that an output of the resonator (300c) is buffered from peripheral loads ($C_b$). It is further described a method for producing the described electronic oscillator circuit (290).

Fig. 3

EP 2 224 589 A1

**Description**

FIELD OF THE INVENTION

The present invention relates to the technical field of electronic oscillators circuits. In particular, the present invention relates to an electronic oscillator circuit, which can be realized by means of a micro electromechanical system (MEMS) and which is operable with a low power consumption. Further, the present invention relates to a method for producing an electronic oscillator circuit as described above.

BACKGROUND OF THE INVENTION

Electronic components inside flat objects, such as tags, bank- or identification (ID) cards require a low profile of typically less than 0.5 mm. Flat, low-cost, and low-power real time clocks (RTCs) and frequency reference oscillators (RFOs) are required residing inside these flat objects for future applications for instance in the e-security, for protecting pharmaceutical products, and/or for the food industry.

Known RTCs make use of quartz crystals with a height profile that typically exceeds the allowed sub-mm specification needed for their incorporation into flat products like cards, tags, and sheets of (value) paper. The main reason for this is because the packaging technology being used to encapsulate the quartz crystal is not suitable for miniaturization. Furthermore, quartz resonators cannot be integrated on a Silicon (Si) chip. Therefore, the integration of a complete oscillator consisting of the crystal and amplifier cannot be realized on a single chip and further prohibits the miniaturization of RTCs and RFOs.

By contrast thereto, a micro electromechanical system (MEMS) resonator can be processed and packaged using surface micro-machining techniques. Surface micro-machining is a technique whereby freestanding and moveable structures are made on top of a substrate using thin film deposition and etching techniques. In this way, both the resonator and its package can be processed on top of e.g. a Si wafer. The packaged resonator has a height of only several thin films measuring about 10 $\mu$m in total thickness. Furthermore, surface micro-machining allows for the definition of many thousands of packaged resonators onto a single wafer without making use of expensive assembly steps. Therefore, the production cost associated with micro-machining decrease when the area occupied by a single device decreases. In this way, miniaturization of the resonator also has cost advantage.

MEMS based oscillators allow for low profile and low cost clocks and oscillators. However, they typically have the disadvantage of a comparatively high power consumption. However, power consumption requirements for clocks used for instance in smart-cards and/or Radio Frequency Identification (RFID) tags can be extremely tight, since power supply is very limited due to small available volume to hold e.g. a battery. Some applications require a power consumption of less than one $\mu$W, making these applications even tough to meet with well established and mature quartz technology.

WO 2007/036820 A2 discloses several oscillators based on MEMS technology. In Figure 1 of this document there is shown a so called "self-gaining" MEMS resonator, which is based on the piezo-resistive properties of Si. This type of piezo-resistive resonators does not need additional amplification between in- and output in order to obtain a self-preserving oscillation.

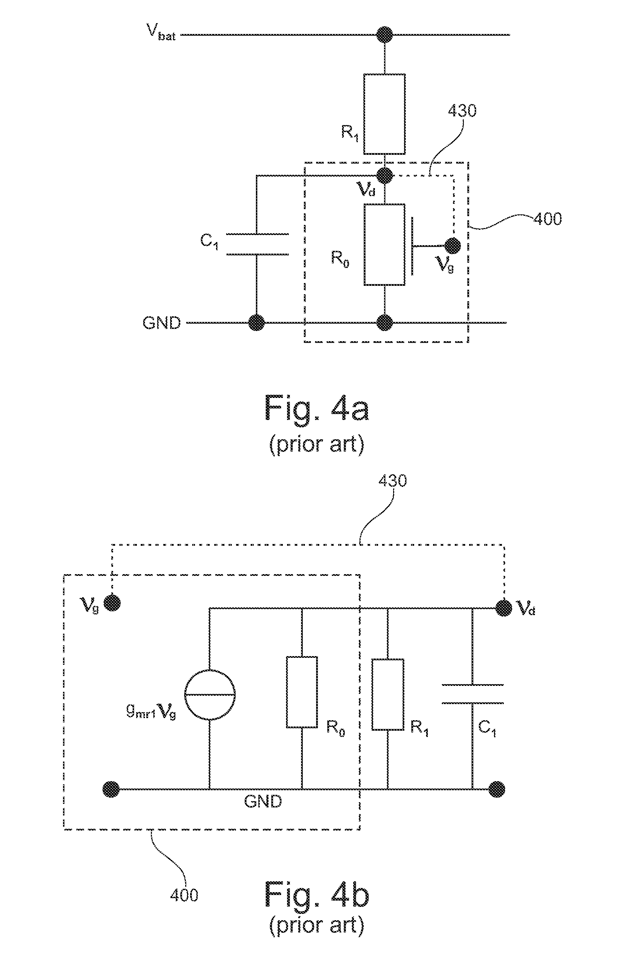

Figure 4a shows a circuit diagram of a known oscillator layout. Figure 4b shows the equivalent small signal model of the circuit depicted in Figure 4a. It is to be noted that the small signal model is based on the common small signal modeling analysis method, wherein in electrical engineering nonlinear devices are described in terms of linear equations. Thereby, no DC information is taken into account. In other words, biasing lines are not depicted in Figure 4b. This linearization is done by first calculating the DC bias point, i.e. the voltage/current levels present when no signal is applied, and then forming linear approximations about this point.

As can be seen from Figures 4a, the oscillator layout comprises a piezo-resistive resonator 400, an external capacitor $C_1$, an external resistor $R_1$ and an internal resistor $R_0$. The external capacitor $C_1$ is used for phase shifting in order to obtain a self-sustaining oscillation. The external resistor $R_1$ is used for biasing the piezo-resistive resonator 400 with respect to a supply voltage $V_{bat}$. According to the embodiment described here the supply voltage $V_{bat}$ is provided by a battery. The resistor $R_1$ can be used to further optimize the oscillator by adjusting a proper operation point for the oscillator. It has to be mentioned that the resistor $R_1$ is not essential for the function of the oscillator. The resistor $R_1$ can be replaced for instance by a current source.

In Figure 4b the oscillator itself is depicted by its Lorenz function $g_{mrb}v_g$ representing the transconductance for the piezo-resistive resonator 400.

As can be seen from Figure 4b, the output $v_d$ of the piezo-resistive resonator 400 is fed back to the input $v_g$ of the piezo-resistive resonator 400 via a feedback line 430. The capacitor $C_1$ connected parallel to the piezo-resistive resonator 400 transforms the impedance of the piezo-resistive resonator 400 and provides the above mentioned phase shift in order to get a self-sustaining oscillator operation. It is noted that due to the resistance of the interconnections between the different circuit devices in a real circuit and the limitations with respect to the capacity that can be provided by means of the capacitor $C_1$ in particular in a fully integrated circuit, typically no full compensation of the $\pi/2$ phase shift caused by the piezo-resistive resonator 400 can be provided.

At this point it is mentioned that a modification of the feedback line 430 would also be possible. In particular it is also possible to obtain a self-sustaining oscillation if the feedback line 430 is omitted and instead a non-depicted feedback line is used which connects the input $v_g$ of the piezo-resistive resonator 400 with the lower connector line being at ground level GND.

The oscillation condition for the oscillator layout depicted in Figures 4a and 4b is met when the following equation (1) is fulfilled:

$$\text{Equation (1)} \qquad \frac{1}{2} g_{mr1} R_{tot} > 1$$

Thereby, the transconductance $g_{mr1}$ is a Lorenz function on frequency and has its maximum at the mechanical resonance frequency of the resonator. The width of the Lorenz function is inversely proportional to the Quality-factor Q of the mechanical resonance. Q can be in the order of 10.000 to 100.000.

The parameter $R_{tot}$ is given by the following equation (2):

$$\text{Equation (2)} \qquad R_{tot} = \frac{R_0 R_1}{R_0 + R_1}$$

The maximum oscillator gain is obtained when the following equation (3) is met.

$$\text{Equation (3)} \qquad \omega_0 C_1 R_{tot} = 1$$

Thereby, $\omega_0$ is the mechanical resonance angular frequency of the piezo-resistive resonator 400.

It has to be mentioned that by using the piezo-resistive properties of Si it is possible to realize so called self-gaining resonators. This type of piezo-resistive resonators does not need additional amplification between in- and output in order to get a sustaining oscillation.

The power consumption of the oscillator layout depicted in Figures 4a and 4b is determined by the bias current through the resistors $R_0$ and $R_1$ and can be minimized by increasing their values. However $R_{tot}$ should remain matched to $C_1$ through equation (3) in order to obtain a sufficient gain for a self sustaining operation.

$C_1$ will consist of a least one bondpad with a finite capacitance when the oscillator output is fed to another chip. In practice this will limit the maximum values of $R_0$ and $R_1$ and, as a result, the minimum consumed power. For example, when $C_1 = C_{bondpad} = 1$ pF and the oscillation angular frequency $\omega_0 = 2\pi \times 100E3$ rad/s (corresponding to an oscillation frequency of 100 kHz), than equation (3) gives $R_{tot} = 1.6$M$\Omega$ and thus $R_1 = R_0 = 3.2$ M$\Omega$. The resulting power consumption of the oscillator is given by equation (4):

$$\text{Equation (4)} \qquad P = \frac{V_{bat}^2}{R_0 + R_1}$$

When the supply voltage $V_{bat} = 2$ V, than the minimum consumed power is 0.6 $\mu$W. In view of the small dimensions for batteries in miniaturized flat objects such as tags, bank- or ID cards, such a power consumption is too large for many applications.

US 5,920,234 discloses a buffered oscillator transmitter arrangement for power specific applications having parasitic impedances. The buffered oscillator includes a resonator for generating a reference signal and an amplifier coupled with the resonator for amplifying the reference signal. A resonant tank generates an oscillating output signal in response to the amplified reference signal. A buffer circuit buffers the oscillating output signal and lowers the output impedance. The amplifier normally consists of at least one transistor and should be integrated on the same chip as the resonator in order to avoid any comparatively large bondpad capacitances between the oscillator and buffer. However, this requires that the transistor and the oscillator are made in the same process flow. In practice this might be very complicated, costly, or just technically impossible.

There may be a need for providing an oscillator circuit, which (a) can be realized by means of a Micro electromechanical System (MEMS), which (b) can be produced on one chip by means of wafer processing technology and which (c) is operable with a particular low power consumption.

OBJECT AND SUMMARY OF THE INVENTION

This need may be met by the subject matter according to the independent claims. Advantageous embodiments of the present invention are described by the dependent claims.

According to a first aspect of the invention there is provided an electronic oscillator circuit. The provided electronic oscillator circuit comprises (a) a resonator; (b) a first resistor element, which is coupled to the resonator, wherein in response to a motion of the resonator the resistance of the first resistor element is modulated; and (c) a second resistor element, which is connected downstream with respect to the resonator in such a manner that an output of the resonator is buffered from peripheral loads.

This first aspect of the invention is based on the idea that by adding a second resistor element downstream with respect to a resonator, the output of the resonator can be effectively isolated from any peripheral loads. The peripheral loads may be any internal or external loads, which are directly or indirectly connected to the output of the resonator. An internal peripheral load may be for instance the capacitance of bondpads, which are used for connecting the electronic oscillator signal with external electronic devices. External peripheral loads may be any loads which are not associated with components of the electronic oscillator circuit itself.

The first resonator element may represent an amplifying element for the resonator. By biasing the first resistor element with an appropriate voltage and/or current the first resistor element may bring the resonator into oscillation.

The resistance value of the second resistor element may also be modulated as a result of the resonator's motion. By biasing the second resistor element with a voltage or current the second resistor element may also be used as an amplifying element for driving an external load. Descriptive speaking, the second resistor element can be used for sending the oscillation signal, which has been provided by the resonator, to the outside world of the whole electronic oscillator circuit.

The first resistor element may be matched to the impedance of the resonator and other elements in an oscillation loop being associated with the resonator. The second resistor may be matched to loading impedances being external with respect to the described oscillator circuit.

The first resistor element and the resonator may be coupled both in a mechanical and in an electrical manner. Thereby, the resonator and the first resistor element may form an oscillator of the described electronic oscillator circuit. The first resistor element, which changes its resistance when the resonator resonates, may be used for providing a self-preservation of an oscillating movement of the resonator. The energy being necessary for providing the resonator's self-preservation may be taken in a known manner from any electrical power source.

The second resistor element and the resonator may be connected with each other in an electrical manner. In addition to that also a mechanical connection may be provided between the second resistor element and the resonator.

The first resistor element and/or the second resistor element may comprise any material, which, upon a deformation, changes its resistance. Thereby, the term resistor or resistance have to be understood in a wide manner. For instance, the first resistor element and/or the second resistor element may change its impedance upon any mechanical deformation. In this context an impedance change may be caused by a change of the real part and/or the imaginary part of any complex resistance.

According to a further embodiment of the invention the first resistor element and/or the second resistor element comprises a piezo-resistive material. This may provide the advantage that the first resistor element and/or the second resistor element may exhibit a high resistance sensitivity with respect to only small mechanical deformations. A further advantage of using a piezo-resistive material can be seen in the matter of fact that the described electronic oscillator circuit may be realized with materials which are already used for known electronic oscillator circuits and which allow for a reliable processing.

According to a further embodiment of the invention the resonator, the first resistor element and the second resistor element are formed on a single chip. By integrating both resistor elements together with the resonator on one and the same chip any bondpad capacitances between the first resistor element and the second resistor element representing a buffer resistor element can be avoided.

According to a further embodiment of the invention a movable electrode of the resonator, the first resistor element and the second resistor element represent a micro electromechanical system. This may provide the advantage that the whole electronic oscillator circuit can be realized within a miniaturized configuration. Therefore, by contrast to known oscillator circuits comprising for instance quartz crystals, the described electronic oscillator circuit will be applicable for particularly small and/or flat objects, such as tags, bank- or ID cards.

According to a further embodiment of the invention the second resistor element is coupled to the resonator in such a manner, that the resistance of the second resistor element changes when the resonator resonates. This may provide the advantage that the described electronic oscillator circuit can be realized by means of a single resonating body.

Specifically, the described electronic oscillator circuit may comprise a single resonator only. Thereby, the single resonator may incorporate and/or may be coupled to both the first resistor element and the second resistor element.

By mechanically coupling both the first resistor element and the second resistor element to one resonator it can be ensured in a simple and effective manner, that the resonance frequencies of (a) the resonator and the assigned first resistor element and (b) the second resistor element automatically merge to a common resonance frequency. This common resonance frequency may be determined by the combination of all masses and spring constants being associated with the single resonator, the first resistor element and the second resistor element.

According to a further embodiment of the invention the resonator comprises an electrode which is adapted to perform an oscillating rotational movement. This may provide the advantage that the resonator can be realized easily. This holds in particular for known production methods for micro electromechanical systems.

According to a further embodiment of the invention the electronic oscillator circuit further comprises (a) a first electrical power source, which is connected with the first resistor element, and (b) a second electrical power source, which is connected with the second resistor element.

The first and/or the second electrical power source may provide the resonator with electrical energy. Thereby, the first and/or the second electrical power source may be realized either by means of a voltage source or a current source. In case at least one of the electrical power sources is a voltage source, an appropriate biasing resistor should be used in order to provide for a reliably power supply and for a appropriate limitation of the currents flowing through the respective resistor element.

According to a further embodiment of the invention the first electrical power source is a voltage source and the second electrical power source is a current source. This may provide the advantage that the resonator can be operated conveniently with a known voltage supply source. Thereby, the major part of the energy being necessary for maintaining an oscillation of the resonator can be provided by the voltage supply source respectively the voltage source. By selecting a proper value for a biasing resistor of the first resistor element the power consumption of the resonator can be kept very small.

The current source may contribute not or only weakly to the described oscillation maintenance. The current provided by the current source, which current is flowing through the second resistor element, can be used for sensing the resistance respectively the impedance of the second resistor element. Thereby, a time varying voltage drop will be produced upon a forced vibration respectively a forced deformation of the second resistor element. The corresponding time dependent voltage may represent the output signal of the described electronic oscillator circuit.

According to a further embodiment of the invention theThe electronic oscillator circuit further comprises a further resonator, which is connected downstream with respect to the resonator in such a manner that the output of the resonator is buffered from the peripheral loads.

This embodiment of the invention is based on the idea that by buffering the output of the resonator by means of a further resonator connected downstream with the resonator, the output of the resonator can be effectively isolated from any peripheral loads. The peripheral loads may be any internal or external loads, which are directly or indirectly connected to the output of the further resonator. An internal peripheral load may be for instance the capacitance of bondpads, which are used for connecting the electronic oscillator signal with external electronic devices. External peripheral loads may be any loads which are not associated with components of the electronic oscillator circuit itself.

The described connection between the resonator, which could also be denominated a primary resonator, and the further resonator, which could also be denominated a secondary resonator, may be simply realized by connecting the output of the resonator with the input of the further resonator.

By contrast to using a known amplifier for buffering the resonator output from external loads the described buffering by means of the further resonator may provide the advantage that both resonators can be formed by means of the same process flow. In addition, both resonators could be formed by means of the same MEMS and/or semiconductor processing steps. This is typically not possible for a known buffer amplifier, which comprises at least one transistor and which therefore typically cannot be effectively integrated on one and the same chip as the resonator in order to avoid any bondpad capacitances between the oscillator and buffer.

Forming both the resonator and the further resonator on a single chip may provide the advantage that any bondpad capacitances between the resonator and the further resonator can be avoided. Therefore, for the resonator the value for the parameter $C_1$ of the above given equation (3) can be kept very low. Hence, when taking into account the above given equation (2) the values for the biasing resistor $R_1$ and the internal resistor $R_0$ of the resonator can be so big such that the power consumption (see equation (4)) of the resonator will be very small.

For example, if the effective capacitance seen at the output of the resonator is 10 fF, when having a supply voltage $V_{bat}$ = 2 V, the resistors $R_1$ and $R_0$ can each have a resistivity of for instance 320 MΩ. According to equation (4) the resulting power consumption would only be 6,25 nW.

The described implementation of both resonators on one and the same chip may be carried out in a straightforward and efficient way since the further resonator respectively the buffer resonator can be made in the same process flow as the resonator used in the oscillator loop. It has to be mentioned that also biasing resistors, which might be used to adjust a proper operating point for the first and/or the second resistor, could also be formed on the same chip.

It has to be mentioned that the resonator drives the further resonator. This may mean that a forced vibration is imposed onto the further resonator. Therefore, it is not necessary that the further resonator fulfills for instance the above mentioned maximum oscillator gain given by equation (3). As a consequence, the choice for the values of the corresponding biasing resistor $R_1$ and the internal resistor $R_0$ of the further resonator will not be limited by the above given equation (3) and also these values can be selected in such a way that also the further resonator comprises only a very small power consumption.

In other words, even though the described electronic oscillator circuit comprises two resonators which will have to be operated, by the above described measures for reducing the power consumption the overall power consumption can be much smaller as the power consumption of a single resonator which has to fulfill the above given equations (1) and (3).

According to a further embodiment of the invention the resonator and the further resonator have the same resonance frequency. This may provide the advantage that the overlap on the frequency scale between the two resonators will be maximal. As a consequence, also the buffering respectively the isolating function of the further resonator will be maximized.

In other words, by choosing the same resonance frequency for both resonators the whole electronic oscillator signal benefits from a high transconductance at resonance.

According to a further embodiment of the invention the electronic oscillator circuit further comprises a feedback line, which connects an input of the resonator with an output of the resonator. Alternatively, the feedback line can connect the input of the resonator with a reference voltage of the resonator. Thereby, the reference voltage may be for instance a ground voltage. The described feedback line may provide the advantage that the resonator can be easily operated in such a manner that a sustaining oscillation can be guaranteed.

According to a further embodiment of the invention the electronic oscillator circuit further comprises (a) a first biasing resistor, which is connected with the resonator and which is capable of being connected with a first supply voltage in such a manner that the resonator is provided with electrical power and (b) a second biasing resistor, which is connected with the further resonator and which is capable of being connected with a second supply voltage in such a manner that the further resonator is provided with electrical power. This may provide the advantage that the working point for the resonator and/or for the further resonator can be adjusted easily by selecting a proper value for the respective biasing resistor. Of course, the proper value for the respective biasing resistor will depend on the height of the available supply voltage.

It has to be mentioned that the first and the second supply voltage may be provided by one and the same voltage source, which is connected to the described electronic oscillator circuit. Therefore, preferably the first and the second supply voltage are the same.

As has already been mentioned above, the first biasing and/or the second biasing resistor can be formed together with both resonators on one and the same chip.

According to a further embodiment of the invention the electronic oscillator circuit further comprises (a) a first current source, which is connected with the resonator and which is capable of providing the resonator with electrical power and (b) a second current source, which is connected with the further resonator and which is capable of providing the further resonator with electrical power.

The described use of one or two current sources may provide the advantage that the respective resonator can be provided with electrical power in a very sensitive and highly efficient way. Thereby, the current flow can be adjusted very precisely to an optimal nominal value.

According to a further embodiment of the invention the electronic oscillator circuit further comprises (a) a first biasing resistor, which is connected with the resonator and which is capable of being connected with a first supply voltage in such a manner that the resonator is provided with electrical power and (b) a second current source, which is connected with the further resonator and which is capable of providing the further resonator with electrical power. This may provide the advantage that the resonator can be operated conveniently with a known voltage supply source. By selecting a proper value for the first biasing resistor $R_1$ and the internal resistor $R_0$ of the resonator the power consumption of the resonator can be kept very small even when obeying the above given equations (1) and (2). Further, the internal resistance of the further resonator and the supply current $I_{supply}$ provided by the second current source can be chosen to be much lower without affecting the oscillation condition.

According to a first aspect of the invention there is provided a method for producing an electronic oscillator circuit. The described the method comprises (a) providing a resonator; (b) coupling a first resistor element to the resonator, wherein in response to a motion of the resonator the resistance of the first resistor element is modulated; and (c) connecting a second resistor element downstream with respect to the resonator in such a manner that an output of the resonator is buffered from peripheral loads.

This second aspect of the invention is based on the idea that a second resistor element can provide an excellent buffering functionality with respect to any peripheral loads. Thereby, the output of the resonator is connected at least to the second resistor element such that peripheral loads and in particular capacitances can be decoupled respectively isolated from the resonator.

For the sake of completeness it is pointed out that the described production method can be used for realizing any one of the above described embodiments of the above described electronic oscillator circuit. In particular, an electronic oscillator circuit comprising two resonators, a resonator representing a primary resonator and a further resonator representing a secondary resonator can be realized, wherein the secondary resonator is connected downstream with respect to the primary resonator in such a manner that the output of the primary resonator is buffered from peripheral loads.

It has to be noted that embodiments of the invention have been described with reference to different subject matters. In particular, some embodiments have been described with reference to apparatus type claims whereas other embodiments have been described with reference to method type claims. However, a person skilled in the art will gather from the above and the following description that, unless other notified, in addition to any combination of features belonging to one type of subject matter also any combination between features relating to different subject matters, in particular between features of the apparatus type claims and features of the method type claims is considered as to be disclosed with this application.

The aspects defined above and further aspects of the present invention are apparent from the examples of embodiment to be described hereinafter and are explained with reference to the examples of embodiment. The invention will be described in more detail hereinafter with reference to examples of embodiment but to which the invention is not limited

BRIEF DESCRIPTION OF THE DRAWINGS

Figure 1 shows a plan view of a piezo-resistive resonator, which can be used for the resonator and/or for the further resonator of an oscillator circuit in accordance with the present invention,
Figure 2 shows an electronic oscillator circuit comprising a resonator and a further resonator buffering the oscillator signal provided by the resonator from any peripheral loads.
Figure 3 shows a layout of an electronic oscillator circuit comprising a resonator being coupled to a first resistor element, wherein a second resistor element is provided for buffering the resonator from peripheral loads.
Figure 4a shows a circuit diagram of a known oscillator comprising a piezo-resistive resonator, a capacitor and a resistor.
Figure 4b shows the equivalent small signal model of the circuit depicted in Figure 3a.

DESCRIPTION OF EMBODIMENTS

The illustration in the drawing is schematically. It is noted that in different figures, similar or identical elements are provided with the same reference signs or with reference signs, which are different from the corresponding reference signs only within the first digit.

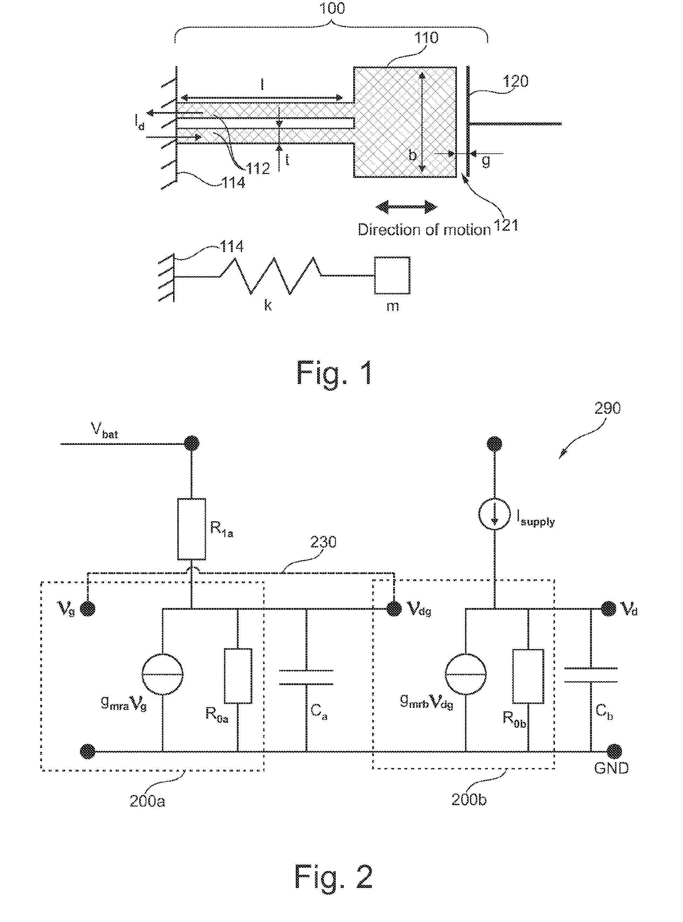

Figure 1 shows a plan view of a piezo-resistive resonator 100, which can be used for the resonator and/or for the further resonator of an oscillator circuit, which is described below in more detail and which represents a preferred embodiment of the present invention. The piezo-resistive resonator 100 comprises piezo-resistive conductor lines 112 of a width t and a length 1. The piezo-resistive conductor lines 112 are attached to a fixed anchor 112 at the one side and to a resonator electrode 110 at the other side. The resonator electrode 110 comprises an essentially square shape with a width b and a not shown height h. The resonator electrode 100 faces an actuation electrode 120 forming a plate capacitor with a gap g between the resonator electrode 110 and the actuation electrode 120.

Applying a voltage between the resonator electrode 110 and the actuation electrode 120 causes a deformation of the piezo-resistive conductor lines 112 changing the electrical resistance of the piezo-resistive conductor lines 112 by means of the known piezo-resistive effect. The variation of the electrical resistance is sensed with a current $I_d$ passing the piezo-resistive conductor lines 112 and the resonator electrode 110.

The behavior of the piezo-resistive resonator 100 can be modeled as a spring-mass system as indicated in the lower part of Figure 1. The spring-mass system is characterized by a spring constant k essentially determined by the mechanical properties of the piezo-resistive conductor lines 112 and the mass m essentially determined by the resonator electrode 110. The mechanical properties of the piezo-resistive conductor lines 112 are essentially determined by the material and the geometric dimensions of the conductor lines 112. The spring constant k and the mass m determine the resonance frequency of the piezo-resistive resonator.

Figure 2 shows an electronic oscillator circuit 290. The electronic oscillator circuit comprises a piezo-resistive resonator 200a and a further piezo-resistive resonator 200b. The further piezo-resistive resonator 200b is connected downstream with respect to the piezo-resistive resonator 200a. According to the embodiment described here this is realized by connecting an output of piezo-resistive resonator 200a with an input of the further piezo-resistive resonator 200b. The corresponding common node is denominated in Figure 2 with $v_{dg}$.

As can be seen from Figure 2 the first resonator 200a is electrically powered by a supply voltage $V_{bat}$, which is connected to a not depicted battery. The second resonator 200b is electrically powered by a current source $I_{supply}$. According to the embodiment described here $V_{bat}$ is 2 Volts above ground voltage, which is indicated in Figure 2 by GND.

The piezo-resistive resonator 200a, which comprises an input node $v_g$, comprises a first transconductance $g_{mra}v_g$ and a resistor $R_{0a}$, is connected via a biasing resistor $R_{1a}$ to the supply voltage $V_{bat}$. The further piezo-resistive resonator 200b, which comprises an output node $v_d$, comprises a second transconductance $g_{nub}v_{dg}$ and a resistor $R_{0b}$, is connected via a current source $I_{supply}$ to the supply voltage $V_{bat}$. A phase shifting capacitor $C_a$ is assigned to the piezo-resistive resonator 200a. An external capacitor $C_b$ is assigned to the further piezo-resistive resonator 200b. The value for the external capacitor $C_b$ can include all external capacitance such as in particular a comparatively large capacitance caused by a bondpad.

A feedback line 230 is provided, which extends between the intermediate node $v_{dg}$ and the input node $v_g$ of the resonator 200a. As has already been described above the feedback line 230 helps that the resonator 200a can be easily operated in oscillation sustaining mode.

It is pointed out that also a modification of the feedback line 430 would be possible. In particular it is also possible to obtain a self-sustaining oscillation if the feedback line 230 is omitted and instead a non-depicted feedback line is used which connects the input $v_g$ of the piezo-resistive resonator 200a with GND voltage.

The further piezo-resistive resonator 200b provides an excellent buffering function for the oscillator signal provided by the piezo-resistive resonator 200a from any peripheral loads.

The described oscillator circuit 290 comprising two MEMS resonators 200a, 200b can deliver an ultra-low power operation. Therefore, the power consumption of MEMS oscillators based on piezo-resistive resonators can be reduced. Any parasitic bondpad capacitance from the oscillator loop is eliminated using the further piezo-resistive resonator 200b to buffer the oscillator signal provided by the resonator 200a from any peripheral loads, such as bondpad capacitance or off-chip loads. Preferably, the further resonator 200b has the same resonance frequency as the resonator 200a in order to benefit from the high transconductance at resonance. However, the resistance $R_2$ and the supply current $I_{supply}$ for the further resonator 200b can be chosen to be much lower without affecting the overall oscillation condition. The buffer resonator 200b can be integrated on the same chip as the resonator 200a in order to avoid any bondpad capacitances between the resonator representing the primary oscillator 200a and the further resonator representing the buffer oscillator 200b. The integration on a single chip of the two resonators 200a, 200b including biasing resistors is very comfortable since the buffer resonator 200b can be made in the same process flow as the resonator 200a used in the oscillator loop.

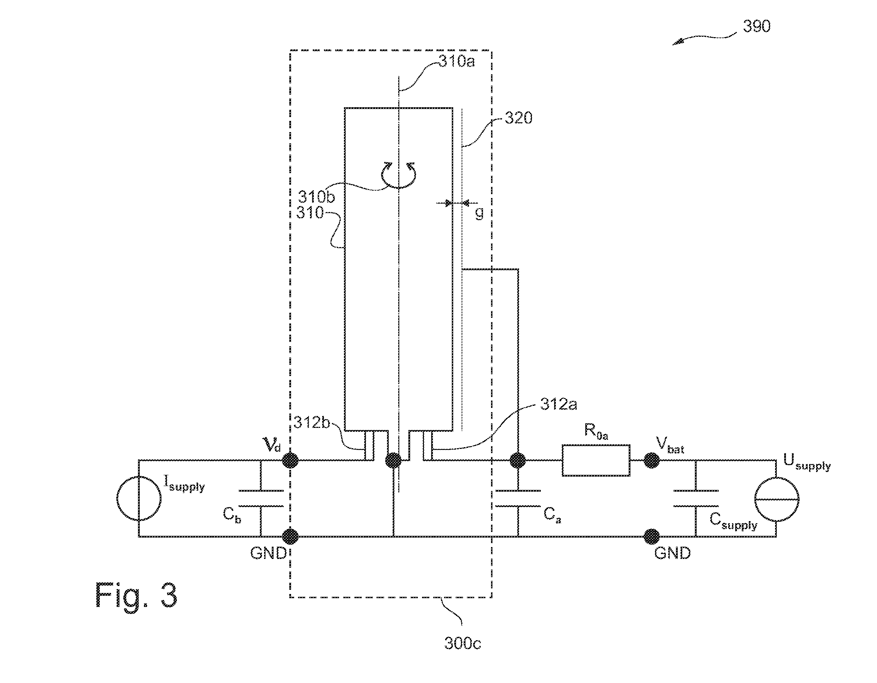

Figure 3 shows a layout of an electronic oscillator circuit 390. The electronic oscillator circuit 390 comprises a piezo-resistive resonator 300c having a resonator electrode 310 and an actuation electrode 320. A gap between the actuation electrode 320 and resonator electrode 310 is indicated with reference numeral g.

According to the embodiment described here the resonator electrode 310 is suspended with respect to a not depicted substrate in such a manner, that the resonator electrode 310 is capable of rotating around a rotational axis 310a in an oscillating manner. The corresponding oscillating rotational movement is denominated with reference numeral 310b.

The piezo-resistive resonator 300c further comprises a first piezo-resistive element 312a and a second piezo-resistive element 312b. Both piezo-resistive elements 312a and 312b are both mechanically and electrically coupled respectively connected to the resonator electrode 310 in such a manner, that, when the resonator electrode 310 rotates in an oscillating manner, the piezo-resistive elements 312a and 312b are periodically compressed and elongated. Thereby, the electrical resistance of the piezo-resistive elements 312a and 312b changes also in a periodical manner.

The first piezo-resistive elements 312a is connected to a voltage supply source $U_{supply}$ via a resistor $R_{0a}$. A node connecting the resistor $R_{0a}$ respectively the whole piezo-resistive resonator 300c with the voltage supply source is indicated with reference numeral $V_{bat}$.

An external capacitance $C_{supply}$ being related for instance to a bonding connection between the piezo-resistive resonator 310c and the voltage supply source $U_{supply}$ is also depicted in Figure 3. A phase shifting capacitor $C_a$ is connected between the actuation electrode 320 respectively the first piezo-resistive elements 312a and a conductor path being grounded. Therefore, in Figure 3 two nodes of the piezo-resistive resonator 300c, which are arranged at this conductor path, are denominated with reference numeral GND. The two nodes GND are also connected to the resonator electrode 310.

As can be further seen from Figure 3, a current source $I_{supply}$ is connected between a node $v_d$ and GND. The node $v_d$ represents an output of the oscillator circuit 390 described in Figure 3.

The second resistor element 312b provides for an effective buffering of the resonator 300c respectively the output node $v_d$ from peripheral loads, which are indicated with reference numeral $C_b$ in Figure 3.

In the embodiment shown in Figure 3 the second piezo-resistor 312b used for buffering the node $v_d$ is combined with the first piezo-resistor 312a used in the oscillator loop in a single resonating body. This means that the single resonator 300c incorporates two piezo-resistors 312a, 312b. According to the embodiment described here the piezo-resistor 312a used in the oscillator loop has a very high resistance that matches to $C_a$. The piezo-resistor 312b used for buffering has a resistance that is matched to the impedance of the load capacitor $C_b$. The advantage of this embodiment is that the resonance frequency of the buffer side of the resonator 300c and the resonance frequency on the oscillator side of the resonator 300c are automatically matched with respect to each other.

In the particular layout depicted in Figure 3 both piezo-resistors 312a and 312b are combined into a single resonating body. The value of $C_a$ is the sum of the capacitance Ci of the interconnect line between the GND conductor line and the gap capacitance Cg and should be made as small as possible. Possible estimated values of Ci, Cg, and $C_a$ and of other layout characteristic values are given in the following table.

| | |
|---|---|
| $\varepsilon_0$ (F/m) | 8.85E-12 |
| $\varepsilon_r$ oxide | 4.00E+00 |
| Silicon On Isolator thickness (m) | 1.50E-06 |
| thickness of the whole piezo-resistive resonator (m) | 1.00E-06 |
| gap width (m) | 2.00E-07 |
| | |
| areal density of Ci (F/m^2) | 3.54E-05 |
| area of capacitor formed over gap g (m^2) | 3.00E-09 |
| Ci (F) | 1.06E-13 |
| length density of Cg (F/m) | 6.64E-11 |
| length of the gap g (m) | 3.00E-04 |
| Cg (F) | 1.99E-14 |
| | |
| $C_a$ (F) | 1.26E-13 |

It should be noted that the term "comprising" does not exclude other elements or steps and "a" or "an" does not exclude a plurality. Also elements described in association with different embodiments may be combined. It should also be noted that reference signs in the claims should not be construed as limiting the scope of the claims.

Reference Numerals:

100 piezo-resistive resonator / electromechanical resonator
110 resonator electrode
112 piezo conductor lines
114 anchor
120 actuation electrode
b width of resonator electrode 110
g gap between actuation electrode 120 and resonator electrode 110
$I_d$ current passing the piezo-resistive conductor lines 112
1 length of piezo conductor lines 112
m mass of resonator electrode
k spring constant
t width of piezo conductor lines 112

200a piezo-resistive resonator / primary piezo-resistive resonator
200b further piezo-resistive resonator / secondary piezo-resistive resonator
230 feedback line

290 oscillator circuit
$C_a$ phase shifting capacitor
$C_b$ capacitor incl. external capacitance (buffered from $v_{dg}$)
$g_{mra}v_g$ first transconductance
$g_{mrb}v_{dg}$ second transconductance
GND ground
$I_{supply}$ current source
$R_{0a}$ resistor
$R_{0b}$ resistor
$R_{1a}$ biasing resistor
$V_{bat}$ supply voltage from battery
$v_g$ input first piezo-resistive resonator
$v_{dg}$ output first piezo-resistive resonator / input second piezo-resistive resonator
$v_d$ output second piezo-resistive resonator

300c piezo-resistive resonator
310 resonator electrode
310a rotational axis
310b oscillating rotational movement
312a first piezo-resistive element / first piezo resistor
312b second piezo-resistive element / second piezo resistor
320 actuation electrode
390 oscillator circuit
$C_a$ phase shifting capacitor
$C_b$ capacitor incl. external capacitance (buffered from $v_d$)
$C_{supply}$ external capacitance
g gap between actuation electrode 320 and resonator electrode 310 GND ground
$I_{supply}$ current source
$R_{0a}$ resistor
$U_{supply}$ voltage supply source
$V_{bat}$ supply voltage from voltage supply source
$v_d$ output of oscillator circuit 390

400 piezo-resistive resonator / electromechanical resonator
430 feedback line
$C_1$ phase shifting capacitor
$g_{mrb}v_g$ transconductance for piezo-resistive resonator 300
$R_0$ resistor
$R_1$ biasing resistor
$V_{bat}$ supply voltage from battery
$v_g$ input piezo-resistive resonator
$v_d$ output piezo-resistive resonator


**Claims**

1.  An electronic oscillator circuit (290, 390) comprising:

    a resonator (100, 200a, 300c);
    a first resistor element (312a), which is coupled to the resonator (100, 200a, 300c), wherein in response to a motion of the resonator (100, 200a, 300c) the resistance of the first resistor element (312a) is modulated; and
    a second resistor element (312b), which is connected downstream with respect to the resonator (100, 200a, 300c) in such a manner that an output of the resonator (100, 200a, 300c) is buffered from peripheral loads ($C_b$).

2.  The electronic oscillator circuit as set forth in claim 1, wherein
    the first resistor element (312a) and/or the second resistor element (312b) comprises a piezo-resistive material.

3.  The electronic oscillator circuit as set forth in claim 1, wherein

the resonator (100, 200a, 300c), the first resistor element (312a) and the second resistor element (312b) are formed on a single chip.

4. The electronic oscillator circuit as set forth in claim 1, wherein
a movable electrode (110, 310) of the resonator (100, 200a, 300c), the first resistor element (312a) and the second resistor element (312b) represent a micro electromechanical system.

5. The electronic oscillator circuit as set forth in claim 1, wherein
the second resistor element (312b) is coupled to the resonator (300c) in such a manner, that the resistance of the second resistor element (312b) changes when the resonator (300c) resonates.

6. The electronic oscillator circuit as set forth in claim 1, wherein
the resonator comprises an electrode (310) which is adapted to perform an oscillating rotational movement (310b).

7. The electronic oscillator circuit as set forth in claim 1, further comprising
a first electrical power source ($U_{supply}$), which is connected with the first resistor element (312a), and
a second electrical power source ($I_{supply}$), which is connected with the second resistor element (312b).

8. The electronic oscillator circuit as set forth in claim 7, wherein
the first electrical power source is a voltage source ($U_{supply}$) and
the second electrical power source is a current source ($I_{supply}$).

9. The electronic oscillator circuit as set forth in claim 1, further comprising a further resonator (200b), which is connected downstream with respect to the resonator (200a) in such a manner that the output ($v_{dg}$) of the resonator (200a) is buffered from the peripheral loads ($C_b$).

10. The electronic oscillator circuit as set forth in claim 9, wherein the resonator (200a) and the further resonator (200b) have the same resonance frequency.

11. The electronic oscillator circuit as set forth in claim 9, further comprising a feedback line (230),
which connects an input ($v_g$) of the resonator (200a) with an output of the resonator (200a), or
which connects an input ($v_g$) of the resonator (200a) with a reference voltage of the resonator (200a).

12. The electronic oscillator circuit as set forth in claim 9, further comprising
a first biasing resistor ($R_{1a}$), which is connected with the resonator (200a) and
which is capable of being connected with a first supply voltage ($V_{bat}$) in such a manner that the resonator (200a) is provided with electrical power and
a second biasing resistor, which is connected with the further resonator and which is capable of being connected with a second supply voltage in such a manner that the further resonator is provided with electrical power.

13. The electronic oscillator circuit as set forth in claim 9, further comprising
a first current source, which is connected with the resonator and which is capable of providing the resonator with electrical power and
a second current source ($I_{supply}$), which is connected with the further resonator (200b) and which is capable of providing the further resonator (200b) with electrical power.

14. The electronic oscillator circuit as set forth in claim 9, further comprising
a first biasing resistor ($R_{1a}$), which is connected with the resonator (200a) and
which is capable of being connected with a first supply voltage ($V_{bat}$) in such a manner that the resonator (200a) is provided with electrical power and
a second current source ($I_{supply}$), which is connected with the further resonator (200b) and which is capable of providing the further resonator (200b) with electrical power.

15. A method for producing an electronic oscillator circuit (290, 390), the method comprising
providing a resonator (200a, 300c);
coupling a first resistor element (312a) to the resonator (200a, 300c), wherein in response to a motion of the resonator (100, 200a, 300c) the resistance of the first resistor element (312a) is modulated; and
connecting a second resistor element (312b) downstream with respect to the resonator (100, 200a, 300c) in such a manner that an output of the resonator (100, 200a, 300c) is buffered from peripheral loads.

Fig. 1

Fig. 2

Fig. 3

# Fig. 4a
(prior art)

# Fig. 4b
(prior art)

Europäisches
Patentamt

European
Patent Office

Office européen
des brevets

**EUROPEAN SEARCH REPORT**

Application Number

EP 09 15 3565

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | WO 2007/036820 A2 (KONINKL PHILIPS ELECTRONICS NV [NL]; STEENEKEN PETER GERARD [DE]; VAN)<br>5 April 2007 (2007-04-05)<br>* page 8, line 25 - page 11, line 6; figures 1, 2, 3a, 3b, 8a, 8c *<br>* page 13, lines 1-19 *<br>----- | 1-15 | INV.<br>H03B5/32<br>H03H9/24 |
| X | WO 2004/053431 A2 (KONINKL PHILIPS ELECTRONICS NV [NL]; VAN BEEK JOZEF T M [NL]) 24 June 2004 (2004-06-24)<br>* page 11, line 15 - page 13, line 6 *<br>* page 18, lines 7-23 *<br>* figures 1, 7 *<br>----- | 1-8,15 | |
| A | US 2004/058591 A1 (AVAZI FARROKH [US]; ANARAKI SIAVASH POURKAMALI [IR]   AYAZI FARROKH [U) 25 March 2004 (2004-03-25)<br>* paragraph [0060]; figure 7 *<br>----- | 1-15 | |
| A | US 4 553 110 A (KLEINBERG LEONARD L [US]) 12 November 1985 (1985-11-12)<br>* figure 5 *<br>* column 4, lines 3-13 *<br>* column 4, lines 29-44 *<br>----- | 1-15 | TECHNICAL FIELDS SEARCHED (IPC)<br><br>H03B<br>H03H |

The present search report has been drawn up for all claims

| Place of search | Date of completion of the search | Examiner |
|---|---|---|
| Munich | 31 August 2009 | Robinson, Victoria |

EPO FORM 1503 03.82 (P04C01)

**ANNEX TO THE EUROPEAN SEARCH REPORT
ON EUROPEAN PATENT APPLICATION NO.**

EP 09 15 3565

This annex lists the patent family members relating to the patent documents cited in the above-mentioned European search report.
The members are as contained in the European Patent Office EDP file on
The European Patent Office is in no way liable for these particulars which are merely given for the purpose of information.

31-08-2009

| Patent document cited in search report | Publication date | Patent family member(s) | Publication date |
|---|---|---|---|
| WO 2007036820 A2 | 05-04-2007 | EP 1980016 A2<br>US 2009026882 A1 | 15-10-2008<br>29-01-2009 |
| WO 2004053431 A2 | 24-06-2004 | AU 2003282286 A1<br>CN 101095282 A<br>EP 1573273 A2<br>JP 2006516836 T<br>KR 20050090995 A<br>US 2006114541 A1 | 30-06-2004<br>26-12-2007<br>14-09-2005<br>06-07-2006<br>14-09-2005<br>01-06-2006 |
| US 2004058591 A1 | 25-03-2004 | AU 2003275159 A1<br>WO 2004027833 A2 | 08-04-2004<br>01-04-2004 |
| US 4553110 A | 12-11-1985 | NONE | |

EPO FORM P0459

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2007036820 A2

- US 5920234 A